Europäisches Patentamt

European Patent Office

Office européen des brevets

(11) Publication number: **0 197 161**
**B1**

(12) **EUROPEAN PATENT SPECIFICATION**

(45) Date of publication of patent specification: **08.06.88**

(21) Application number: **85102663.3**

(22) Date of filing: **08.03.85**

(51) Int. Cl.⁴: **G 03 F 9/00**

(54) Press plate positioning apparatus for automatic drawing machine.

(43) Date of publication of application:
**15.10.86 Bulletin 86/42**

(45) Publication of the grant of the patent:
**08.06.88 Bulletin 88/23**

(84) Designated Contracting States:
**AT CH DE FR GB IT LI SE**

(56) References cited:

**No relevant documents have been disclosed**

(73) Proprietor: **Komori Printing Machinery Co., Ltd.**
**11-1, Azumabashi 3-chome**
**Sumida-ku Tokyo (JP)**

(72) Inventor: **Tsunoda, Teruo**
**2-913-1-C-205, Nishihatsuishi**
**Nagareyama-shi Chiba (JP)**
Inventor: **Numauchi, Hiromitsu**
**4173-30, Kimagase Sekiyado-cho**
**Higashikatsushika-gun Chiba (JP)**
Inventor: **Kurata, Hironobu**
**719-7, Sanada**
**Hiratsuka-shi Kanagawa (JP)**
Inventor: **Kawaguchi, Yoichi**
**1808-7, Yabe-cho Totsuka-ku**
**Yokohama-shi Kanagawa (JP)**
Inventor: **Ishii, Satoshi**
**865-3, Kamikurata-cho Totsuka-ku**
**Yokohama-shi Kanagawa (JP)**
Inventor: **Seki, Masanori**
**1-31-11, Iwase**
**Kamakura-shi, Kamagawa (JP)**
Inventor: **Iwasaki, Masahiro**
**3283-15, Kameino**
**Fujisawa-shi Kanagawa (JP)**
Inventor: **Enomoto, Fukumasa**
**4-36-7-301, Kounandai Kounan-ku**
**Yokohama-shi Kanagawa (JP)**

Courier Press, Leamington Spa, England.

**0 197 161**

(74) Representative: **Kern, Ralf M., Dipl.-Ing.
Kern, Lang & Partner Patent- und
Rechtsanwaltsbüro Postfach 14 03 29
D-8000 München 5 (DE)**

## Description

The present invention relates to a press plate positioning apparatus for positioning a press plate at a predetermined position on a drawing board in an automatic drawing machine for forming reference punch holes in the press plate and drawing register marks thereon.

When a picture pattern is not accurately printed on a press plate or the press plate is not properly mounted on a plate cylinder for printing in a rotary press, especially a multicolor press, printed pictures with good registration cannot be obtained. Conventionally, punch holes are formed at edge portions of the press plate. With reference to the punch holes, the picture pattern is printed on the press plate, and the press plate is mounted on the plate cylinder. More particularly, after the punch holes are formed in the press plate, cross-shaped register marks are drawn on the press plate with reference to the punch holes. The register marks of a film are then aligned with those of the press plate, and the picture pattern is printed on the press plate. Furthermore, when the press plate is to be mounted on the plate cylinder, reference pins are fitted in the corresponding punch holes. When the press plate is mounted in position, the two ends thereof are held by a plate lock up device and the reference pins are removed from the punch holes. In addition, when multicolor printing is performed, registering is adjusted after the impression of the register marks is checked.

The punch holes and the register marks are simultaneously formed in a conventional automatic drawing machine. The conventional automatic drawing machine comprises a drawing board, a pen head arranged above the drawing board and movable in all directions, and a punching machine which is mounted on a frame for fixing the drawing board and which forms a plurality of punch holes. When register marks are to be drawn on the press plate, the press plate is fixed in position on the drawing board and punch pins of the punching machine are vertically moved by an air cylinder or the like to form punch holes. Thereafter, the pen head is driven in accordance with the drawing pattern stored in a memory to draw the register marks.

In this case, in order to make sure that the length between the edge of the press plate and the punch holes is correct, the press plate must be accurately positioned with respect to the punching machine fixed on the frame. In addition, the distance between the edge of the press plate and the punch holes varies in accordance with the type of printing press. There are generally three or four types of conventional printing presses, and the press plate must be accurately positioned for each type.

A conventional automatic drawing machine of this type has a positioning apparatus operated such that a movable stopper thereof abuts against the edge of the press plate. However, in the conventional positioning apparatus, a positioning error exceeds an allowable value due to insufficient rigidity of the stopper. In addition, the positioning operation is cumbersome and time-consuming, or results in an erroneous operation. Positioning precision depends on precision of individual operators. As a result, satisfactory positioning precision and operability cannot be obtained with the conventional positioning apparatuses.

It is, therefore, a principal object of the present invention to provide a press plate positioning apparatus for an automatic drawing machine, wherein the press plate can be easily positioned with high precision.

In order to achieve the above object of the present invention, there is provided a press plate positioning apparatus for an automatic drawing machine for positioning a press plate so as to form punch holes at a punch hole forming edge thereof which is placed and fixed on a drawing board of the machine and draw registration marks at predetermined positions on the press plate, comprising:

an elongated cam plate extending in parallel with a positioning edge of the press plate which extends from the drawing board and which is perpendicular to the punch hole forming edge, the elongated cam plate being moved by manual control means in a direction parallel to the positioning edge and being provided with a plurality of cam surfaces which are arranged in a longitudinal direction thereof and each of which has a plurality of stepwise horizontal surfaces and at least one inclined surface connecting the stepwise horizontal surfaces; and

a plurality of positioning blocks, each of the positioning blocks being adapted not to be moved by block holding means with respect to the positioning edge, being biased downward by block biasing means, being guided by block guide means together with a corresponding gripper block such that the each positioning block is vertically moved by a behavior of the cam surface upon reciprocal movement of the cam plate so as to bring the positioning edge into contact with one of stepwise vertical surfaces, and being locked by clicking means in position.

Figs. 1 to 5 show an embodiment of a press plate positioning apparatus for an automatic drawing machine according to the present invention, in which:

Fig. 1 is a front view showing the main part of the automatic drawing machine;

Fig. 2 is a sectional view of the machine taken along the line II—II of Fig. 1;

Fig. 3 is a sectional view of the machine taken along the line III—III of Fig. 1;

Fig. 4 is a sectional view of the machine taken along the line IV—IV of Fig. 1; and

Fig. 5 is perspective view of a press plate positioning apparatus in the automatic drawing machine.

A preferred embodiment of the present invention will be described with reference to the accompanying drawings.

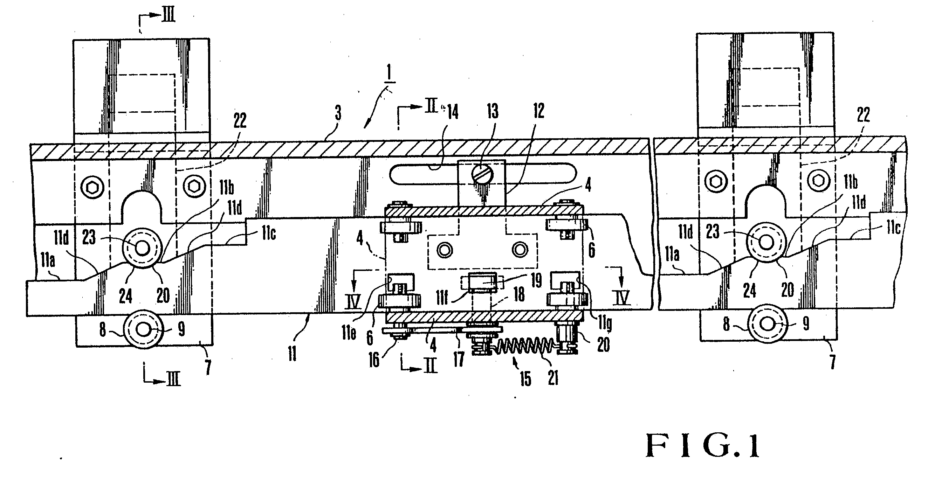

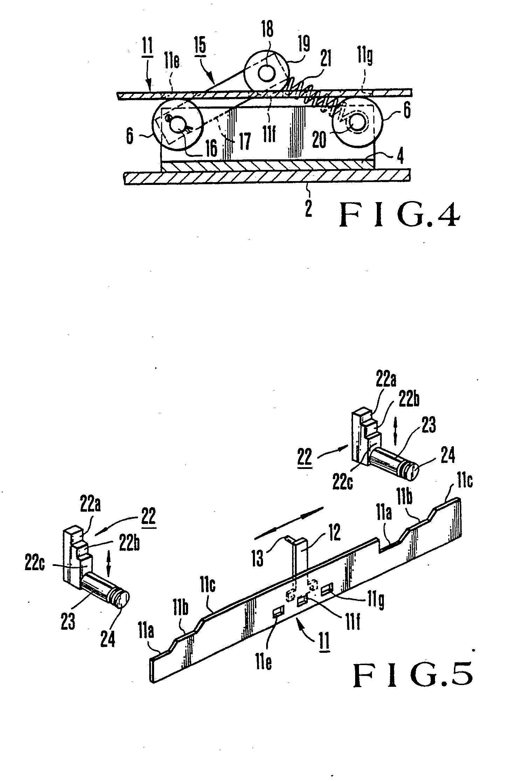

Referring to Figs. 1 to 5, a rectangular drawing board 3 is horizontally fixed between front and rear frames 2 (the front frame is not illustrated) in an automatic drawing machine 1. The drawing board 3 has long sides extending in the right-to-left direction and short sides extending in the front-to-back direction. The upper surface of the drawing board 3 has substantially the same level as that of a projection 2a. A substantially U-shaped bracket 4 is fixed by bolts 5 substantially at the central portion of the inner wall surface of the rear frame 2 whose outer surface portion is connected to the drawing board 3. Four ball bearing guide rollers 6 are pivotally supported at four corners of the bracket 4. A pair of substantially U-shaped gripper blocks 7 (the following description will be made for mainly one of the blocks which is located on the left side of the other) on the rear frame 2. A shaft 9 is mounted by a bolt 10 on the lower end of each gripper block 7. The shaft 9 rotatably supports a collared roller 8. Each end portion of an elongated cam plate 11 (whose shape is best illustrated in fig. 5) is supported by the front and rear collared roller 8, and a T-shaped arm 12 (Fig. 1) is fixed by screws to the central portion of the elongated cam plate 11. When an operator holds a handle 13 fixed on the arm 12 and moves the handle 13 which is guided by an elongated hole 14 formed in the frame 2 in the right-and-left direction of Fig. 1, the cam plate 11 is moved in the right-and-left direction of Fig. 1. As is best illustrated in Figs, 1 and 5, a pair of cam surfaces are formed at the two end portions of the cam plate 11. A click mechanism 15 is arranged at the central portion of the cam plate 11 to stop movement of the cam plate at three different positions. Each cam surface comprises horizontal surfaces 11a, 11b and 11c having different levels and inclined surfaces 11d for connecting these horizontal surfaces 11a, 11b and 11c. Three rectangular holes 11e, 11f and 11g are formed in the central portion of the cam plate 11 at the same pitch as that of the horizontal surfaces 11a, 11b and 11c. The click mechanism 15 is best illustrated by the sectional view of Fig. 4 which is taken along the line IV — IV of Fig. 1. The click mechanism 15 has an arm 17 loosely fitted with a shaft 16 for supporting one of the lower guide rollers 6. A click roller 19 is pivotally supported at the upper end of a pin extending upward from the free end of the arm 17. A tension spring 21 is hooked between the lower end of the pin 18 and a shaft 20 of the other lower guide roller 6 to apply a pivotal force to the arm 17 so as to urge the click roller 19 against the surface of the cam plate 11. When the cam plate 11 is moved fit the click roller 19 in one of the rectangular holes 11e, 11f and 11g, the cam plate 11 is held longitudinally captive at a corresponding one of the horizontal plates 11a, 11b and 11c.

A pair of positioning blocks 22 are mounted at the central portions of the blocks 7 to be vertically moved upon horizontal movement of the cam plate 11, respectively.

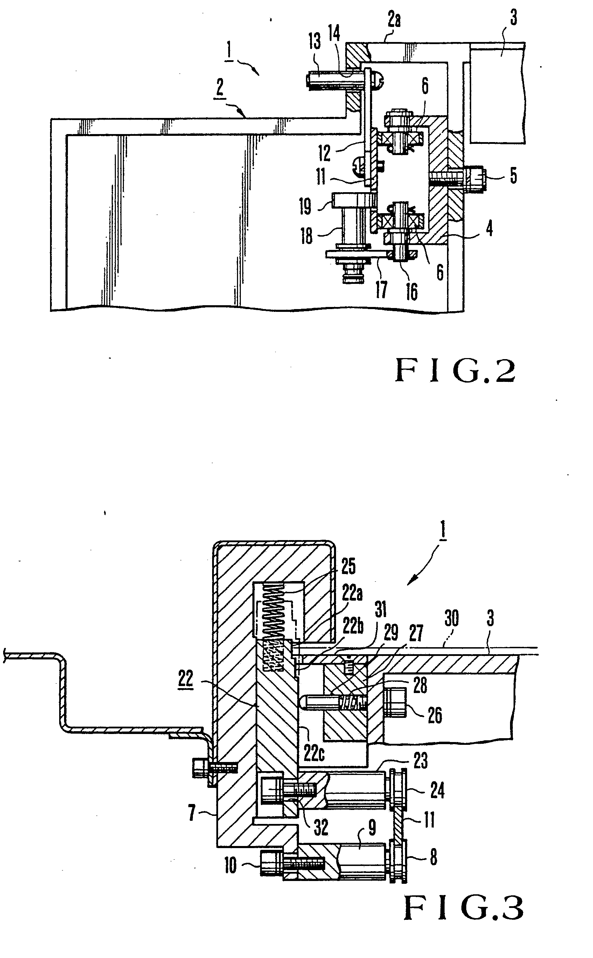

The pair of positioning blocks 22 has the same construction and is exemplified by the block 22 illustrated in Fig. 3. Referring to Fig. 3, the positioning block 22 is surrounded by the gripper block 7 and stands vertically. A roller shaft 23 is mounted at the lower end portion of the block 22. A collared roller 24 is mounted on the shaft 23 and is engaged with the came surface of the cam plate 11. A compression spring 25 is mounted between the upper surface of the positioning block 22 and the upper inner surface of the gripper block 7 to bias the positioning block 22, so that the collared roller 24 is urged against the cam surface. Plunger pins 29 respectively biased by compression coil springs 28 extend through a block 27 fixed by bolts 26 on the drawing board 3. The positioning block 22 is kept vertical by the plunger pins 29. The plunger pins 29 also restrict horizontal movement of the block 22. Three vertical surfaces 22a, 22b and 22c are formed in the block 22 so as to oppose the plunger pins 29. The vertical surfaces 22a and 22b constitute an upper portion of the block 22, and the vertical surface 22c is in contact with the plunger pins 29. The vertical surface 22a, 22b and 22c have the same pitch as that of the horizontal surfaces 11a, 11b and 11c. The positioning edge of a press plate 30 placed on the drawing board 3 is brought into contact with one of the vertical surfaces 22a, 22b and 22c to locate the press plate 30 in position. The sizes of steps between the vertical surfaces 22a, 22b and 22c are determined in accordance with three types of punch holes to be formed in the press plate 30. An abutment plate 31 is screwed on the block 27 at the portion extending from the drawing board 3. Vertical adjustment of the positioning block 22 can be performed through an elongated mounting hole 32 of the roller 23.

The automatic drawing machine 1 has a punching unit (not shown) for forming punch holes in the press plate 30 after the edge of the press plate placed on the drawing board 3 is brought into contact with one of the vertical surfaces 22a, 22b and 22c of the positioning block 22, and a register mark drawing unit (not shown) for drawing register marks in predetermined positions of the press plate 30.

The operation of the automatic drawing machine having the construction described above will now be described. When the operator holds the handle 13 and moves it horizontally along the elongated hole 14, the cam plate 11 coupled to the handle 13 through the arm 12 is moved horizontally over the collared rollers 8. The collared rollers 24 are vertically moved, and the positioning blocks 22 mounted integrally with the collared rollers 24 are vertically moved against the biasing forces of the compression coil springs 25, respectively. One of the horizontal surfaces 11a, 11b and 11c of the cam plate 11 is selected in accordance with the punching positions of the holes for the press plate 30.

Assume that each collared roller 24 is in contact with the corresponding horizontal surface 11b, as shown in Fig. 1. The corresponding positioning block 22 is moved upward by one step from the position indicated by the solid line of Fig. 3. Each vertical surface 22b is exposed from the horizontal surface of the drawing board 3. In this case, the click roller 19 of the click mechanism 15 is engaged with the central rectangular hole 11f and is urged by the tension spring 21 toward the hole 11f. In this state, the horizontal movement of the cam plate 11 is stopped, and the vertical movement of the positioning blocks 22 is also stopped.

The press plate 30 is placed on the drawing board 3 and is positioned laterally. Thereafter, when the press plate 30 is moved to the left of Fig. 3, the positioning edge of the press plate 30 is brought into contact with the vertical surface 22b of the positioning blocks 22. The press plate 30 is then fixed by a fixing unit (not shown) at a predetermined position. The punch holes are formed at positions spaced by predetermined distances from the edge of the press plate 30 and the register marks are drawn at positions spaced by predetermined distances from the edge thereof. When a different type of press plate is used, the cam plate 11 is simply moved horizontally by the handle 13.

As is apparent from the above description, there is provided a press plate positioning apparatus for the automatic drawing machine, comprising an elongated cam plate located below a positioning edge of a press plate which is perpendicular to a punch hole forming edge extending from a drawing board, and a plurality of positioning blocks vertically moved by stepped cam surfaces upon back-and-fourth movement of the elongated cam plate, wherein the positioning edge of the press plate is brought into contact with one of the vertical surfaces formed at the upper portion of each of the positioning blocks. In this manner, positioning of the press plate can be performed with one-touch operation, i.e., back-and-fourth movement of the cam plate. As compared with the conventional automatic drawing machine, operability and operating efficiency ar greatly improved. In addition, different and erroneous operations can be eliminated, thereby facilitating accurate positioning. Since the positioning member has sufficient rigidity, the positioning precision can be improved and registering can be performed with high precision.

**Claims**

1. A press plate positioning apparatus for an automatic drawing machine (1) for positioning a press plate (30) so as to form punch holes at a punch hole forming edge thereof which is placed and fixed on a drawing board (3) of the machine and draw registration marks at predetermined positions on the press plate, characterized by comprising:

an elongated cam plate (11) extending in parallel with a positioning edge of the press plate (30) which extends from the drawing board (3) and which is perpendicular to the punch hole forming edge, said elongated cam plate (11) being moved by manual control means (12, 13) in a direction parallel to the positioning edge and being provided with a plurality of cam surfaces (11a, 11b, 11c, 11d) which are arranged in a longitudinal direction thereof and each of which has a plurality of stepwise horizontal surfaces (11a, 11b, 11c) and at least one inclined surface (11d) connecting said stepwise horizontal surfaces (11a, 11b, 11c); and

a plurality of positioning blocks (22), each of the positioning blocks (22) being adapted not to be moved by block holding means (28, 29) with respect to the positioning edge, being biased downward by block biasing means (25), being guided by block guide means (8, 9, 23, 24) together with a corresponding gripper block (7) such that the each positioning block (22) is vertically moved by a behavior of the cam surface (11a, 11b, 11c and 11d) upon reciprocal movement of the cam plate (11) so as to bring the positioning edge into contact with one of stepwise vertical surfaces (22a, 22b, 22c), and being locked by clicking means (6, 17, 19, 21) in position.

2. An apparatus according to claim 1, characterized in that said elongated cam plate (11) has a plurality of rectangular holes (11e, 11f, 11g).

3. An apparatus according to claim 2, characterized in that said clicking means (6, 17, 19, 21) comprise first and second guide rollers (6), a click roller (19), an arm (17) pivotally coupled to said first guide roller (6) and said click roller (19), and a tension spring (21) hooked between said click roller (19) and said second guide roller (6), said click roller (19) being selectively engaged with one of said rectangular holes (11e, 11f, 11g) in synchronism with the reciprocal movement of said cam plate (11) and the vertical movement of said each positioning block (22).

4. An apparatus according to claim 1, characterized in that said block guide means (8, 9, 23, 24) comprises a first shaft (23) coupled to a lower end portion of said each positioning block (22), a first collared roller (24) coupled to said first shaft (23) and brought into rolling contact with said cam surface (11a, 11b, 11c), a second shaft (9) coupled to said corresponding gripper block (7), and a second collared roller (8) coupled to said second shaft (9) and brought into rolling contact with a lower linear edge of said cam plate (11), said first and second collared rollers (24, 8) being adapted to clamp said cam plate (11) so as to cause said each positioning block (22) to move vertically upon operation of said manual control means (12, 13).

5. An apparatus according to claim 1, characterized in that said manual control means (12, 13) comprises a handle (13) to be operated by an operator and moved along an elongate hole (14), and a T-shaped arm (12) coupled to said cam plate (13).

6. An apparatus according to claim 1, characterized in that said block holding means (28, 29) comprises a plurality of plunger pins (29) and corresponding coil springs (28), distal ends of said plunger pins (29) being in contact with a lowermost surface of said stepwise vertical surfaces (22a, 22b, 22c) of said each positioning block (22).

7. An apparatus according to claim 1, characterized in that said block biasing means (25) comprises a spring (25) held between an upper inner wall surface of said corresponding gripper block (7) and an upper surface of said each positioning block (22).

8. An apparatus according to claims 1 and 2, characterized in that said stepwise horizontal surfaces (11a, 11b, 11c), said stepwise vertical surfaces (22a, 22b, 22c) and said rectangular holes (11e, 11f, 11g) have the same pitch.

## Patentansprüche

1. Druckplattenpositionierungsgerät für einen Zeichenautomaten (1) zur Positionierung einer auf ein Zeichenbrett (3) des Automaten aufgelegten Druckplatte (30), um in Bereich einer Kante Stanzlöcher einzubringen, während gleichzeitig in vorgegebenen Positionen Registrierungsmarkierungen angebracht werden, dadurch gekennziechnet,

daß parallel zur Positionierungskante der auf das Zeichenbrett (3) aufgelegten Druckplatte (30) und senkrecht zu der Stanzloch bildenden Kante eine längliche Nockenplatte (11) vorgesehen ist, welche mit manuellen Mitteln (12, 13) in einer Richtung parallel zur Positionierungskante bewegbar ist, wobei dieselbe in ihrer Längsrichtung mit Nockenflächen (11a, 11b, 11c, 11d) versehen ist, die aus einer Mehrzahl von stufenweise angeordneten horizontalen Nockenflächen (11a, 11b und 11c) von wenigstens einer, die horizontalen Nockenflächen (11a, 11b, 11c) miteinander verbindenden geneigten Oberfläche (11d) aufgebaut sind,

und daß zusätzlich unter Einsatz von entsprechenden Haltemitteln (28, 29) mit Hilfe von entsprechenden Druckmitteln (25) nach abwärts gedrückte Positionierungsblöcke (22) vorgesehen sind, welche unter dem Einfluß von Führungselementen (8, 9, 23, 24) zusammen mit einem entsprechenden Halteblock (7) derart geführt werden, daß bei Hinund Herbewegung der Nockenplatte (11) unter dem Einlfuß der Nockenflächen (11a, 11b, 11c und 11d) eine vertikale Bewegung zustande kommt, demzufolge die jeweilige Posi tionierungskante in Berührung mit einer von stufenweisen vertikalen Oberflächen (22a, 22b, 22c) bringbar ist, und eine Verrastung mit Hilfe eines Rastmechanismus (6, 17, 19, 21) erfolgt.

2. Gerät nach Anspruch 1, dadurch gekennzeichnet, daß die längliche Nockenplatte (11) eine Mehrzahl von rechteckigen Öffnugnen (11e, 11f, 11g) aufweist.

3. Gerät nach Anspruch 2, dadurch gekennzeichnet, daß der Rastmechanismus (6, 17, 19, 21) im wesentlichen aus zwei Führungsrollen (6), einer Rastrolle (19), einem gegenüber der ersten Rastrolle (19) schwenkbaren Arm (17) und einer zwischen der Rastrolle (19) und der zweiten Führungsrolle (6) eingehängten Zugfeder (21) aufgebaut ist, wobei die Rastrolle (19) bei der Hin- und Herbewegung der Nockenplatte (11) und der synchron dadurch ausgelösten vertikalen Bewegung der Positionierungsblöcke (22) in einer der rechteckigen Öffnungen (11e, 11f und 11g) zu liegen gelangt.

4. Gerät nach Anspruch 1, dadurch gekennzeichnet, daß die Blockfübhrungsmittel (8, 9, 23, 24) im wesentlichen aus einer am unteren Ende der Positionierungsblöcke (22) befestigten ersten Achse (23), einer an der ersten Achse (23) befestigten und den Nockenflächen (11a, 11b, 11c) in Rollberührung bringbaren Kragenrolle (24), einer an dem entsprechenden Haltebacken (7) befestigten zweiten Achse (9) und einer an der zweiten Achse (9) befestigten und in Rollberührung mit der unteren Kante der Nockenplatte (11) bringbaren Kragenrolle (8) bestehen, wobei die beiden Kragenrollen (24, 28) die Nockenplatte (11) derart erfassen, daß bei Betätigung der Handbedienungsmittel (12, 13) die Positionierungsblöcke (22) in der vertikalen Richtung bewegbart sind.

5. Gerät nach Anspruch 1, dadurch gekennzeichnet, daß die manuellen Betätigungsmittel (12, 13) aus einem durch die Bedienungsperson erfaßbaren und entlang einer Schlitzöffnung (14) bewegbaren Handgriffes (13) und einem mit der Nockenplatte (11) in Verbindung stehenden T-förmigen Arm (12) bestehen.

6. Gerät nach Anspruch 1, dadurch gekennzeichnet, daß die Blockhaltemittel (28, 29) aus einer Mehrzahl von Andruckstiften (29) und entsprechenden Druckfedern (24) bestehen, wobei die vorderen Enden der Andruckstifte (29) in Berührung mit der untersten Oberfläche (22c) der stufenweisen vertikalen Oberfläche (22a, 22b, 22c) der Positionierungsblöcke (22) stehen.

7. Gerät nach Anspruch 1, dadurch gekennzeichnet, daß das Beaufschlagungsmittel (25) im wesentlichen durch Druckfedern (25) gebildet sind, welche zwischen der oberen Innenoberfläche des Haltebackens (7) und der oberen Oberfläche der Positionierungsblöcke (22) vorgesehen sind.

8. Gerät nach Anspruch 1 und 2, dadurch gekennzeichnet, daß die stufenförmigen horizontalen Oberflächen (11a, 11b, 11c) die stufenweisen vertikalen Oberflächen (22a, 22b, 22c) und die rechteckigen Öffnungen (11e, 11f, 11g) jeweils dieselben gegenseitigen Abstände aufweisen.

## Revendications

1. Appareil pour le positionnement d'une plaque d'impression pour une machine à dessinger automatique (1) afin de positionner une plaque d'impression (30) de manière à former des orifices de poinçonnage sur un de ses bords de formation d'orifice de poinçonnage, laquelle plaque d'impression est placée et fixée sur une table à dessin (3) de la machine, et de façon à tracer des marques de correspondance dans des positions prédéterminées sur la plaque d'impression, ledit appareil étant caractérisé en ce qu'il comprend:
— une plaque (11) en forme de came allongée s'étendant parallèlement à un bord de positionnement de la plaque d'impression (30) qui s'étend depuis ladite table à dessin (3) et qui est perpendiculaire au bord de formation des orifices de poinçonnage, ladite plaque (11) en forme de came allongée étant déplacée par des moyens de commande manuelle (12, 13) dans une direction parallèle au bord de positionnement et comportant une pluralité de surfaces de came (11a, 11b, 11c, 11d) qui sont disposées suivant sa direction longitudinale et dont chacune comporte une pluralité de surfaces horizontales en gradin (11a, 11b, 11c) et au moins une surface inclinée (11d) reliant lesdites surfaces horizontales en gradin (11a, 11b, 11c); et

— une pluralité de blocks de positionnement (22), chacun desdits blocs de positionnement (22) étant adapté de façon à ne pas être déplacé par des moyens de maintien (28, 29) des blocks par rapport au bord de positionnement, en étant solicité vers le bars par des moyens de solicitation (25) des blocs, en étant guidé par des moyens de guidage (8, 9, 23, 24) des blocs simultanément à un block de saisie (7) correspondant, de telle façon qui chacun desdits blocs de positionnement (22) est déplacé verticalement sous l'action de ladite surface de came (11a, 11b, 11c et 11d) suivant le mouvement alternatif de ladite plaque en forme de came (11) de manière à placer le bord de positionnement en contact avec l'une des surfaces verticales en gradin (22a, 22b, 22c), en en étant verrouillé par des moyens d'encliquetage (6, 17, 19, 21) en position.

2. Appareil selon la revendication 1 caractérisé en ce que ladite plaque (11) en forme de came allongée comporte une pluralité d'orifice rectangulaire (11e, 11f, 11g).

3. Appareil selon la revendication 2 caractérisé en ce que lesdits moyens d'encliquetage (6, 17, 29, 31) comprennent des premiers et seconds rouleaux (6) de guidage, un rouleau (19) de'encliquetage, un bras (17) couplé de façon pivotante audit premier rouleau de quidage (6) et audit rouleau d'encliquetage (19), et un ressort de traction (21) accroché entre ledit rouleau d'encliquetage (19) et ledit second rouleau de guidage (6), ledit rouleau d'encliquetage (19) étant sélectivement engagé avec l'un desdits orifices rectangulaires (11e, 11f, 11g) en synchronisme avec le mouvement alternatif de ladite plaque en forme de came (11) et le mouvement vertical de chacun desdits blocs de positionnement (22).

4. Appareil selon la revendication 1 caractérisé en ce que lesdits moyens de guidage des blocs (8, 9, 23, 24) comprennent un premier arbre (23) couplé à une partie d'extrémité inférieure de chacun desdits blocs de positionnement (22), un premier rouleau à gorge (24) couplé audit premier arbre (23) et amené en contact roulant avec ladite surface de came (11a, 11b, 11c), un second arbre (9) couplé audit bloc de saisie correspondant (7), et un second rouleau à gorge (8) couplé audit second arbre (9) et amené en contact roulant avec un bord linéaire inférieur de ladite plaque (11) en forme de came, lesdits premiers et seconds rouleaux à gorge (24, 8) étant adaptés de façon à bloquer ladite plaque (11) en forme de came de façon à provoquer le déplacement vertical de chacun desdits blocs de positionnement (22) après actionnement des moyens de commande manuelle (12, 13).

5. Appareil selon la revendication 1 caractérisé en ce que en ce que lesdits moyens de commande manuelle (12, 13) comprennent une poignée ou levier (13) qui est actionné par un opérateur et qui est déplacé le long d'un orifice de forme allongée (14), un bras (12) en forme de T étant couplé à ladite plaque en forme de came (11).

6. Appareil selon la revendication 1 caractérisé en ce que lesdits moyens de maintien des blocs (28, 29) comprennent une pluralité de goupilles-pistons (29) et des ressorts à boudin ou de compression correspondant (28), les extrémités distales desdites goupilles-pistons (29) étant en contact avec la surface inférieure desdites surfaces verticales en gradin (22a, 22b, 22c) de chacun desdits blocs de positionnement (22).

7. Appareil selon la revendication 1 caractérisé en ce que lesdits moyens de sollicitation (25) des blocs comprennent un ressort (25) maintenu entre la surface de paroi interne supérieure dudit bloc de saisie correspondant (7) et une surface supérieure de chacun desdits blocs de positionnement (22).

8. Appareil selon les revendications 1 et 2 caractérisé en ce que lesdites surfaces horizontales en gradin (11a, 11b, 11c), lesdites surfaces verticales en gradin (22a, 22b, 22c) et lesdits orifices rectangulaires (11e, 11f, 11g) ont le même pas.

F I G.1

0 197 161

F I G. 2

F I G. 3

2

FIG.4

FIG.5